# EUROPEAN PATENT APPLICATION

(11) **EP 1 762 635 A2**
(43) Date of publication of application: **14.03.2007**
(21) Application number: 06254760.9
(22) Date of filing: 13.09.2006
(51) Int. Cl.: C23C 14/35

(54) **Organic light emitting display and a deposition method**

(30) Priority: 13.09.2005 KR 20050085413
(71) Applicant: Samsung SDI Co., Ltd., Suwon-si, Gyeonggi-do (KR)
(72) Inventor: Kim, Han Ki, c/o Samsung SDI Co., Ltd., Yongin-si, Gyeonggi-do (KR); Lee, Kyu Sung, c/o Samsung SDI Co., Ltd., Yongin-si, Gyeonggi-do (KR); Kim, Kyung Hwan, c/o Samsung SDI Co., Ltd., Yongin-si, Gyeonggi-do (KR); Geum, Min Jong, c/o Samsung SDI Co., Ltd., Yongin-si, Gyeonggi-do (KR)
(74) Representative: Mounteney, Simon James

(57) **Abstract**

Disclosed are an organic light emitting display and a deposition method for depositing an electrode or a passivation layer by means of a box cathode sputtering method or a facing target sputtering method by mixing Ar with an inert gas heavier than Ar gas. The present embodiments provide an organic light emitting display including a substrate; a thin film transistor formed on the substrate; a first electrode formed on the thin film transistor; an organic layer formed on the first electrode; and a second electrode layer sputter-deposited on the organic layer by mixing Ar gas with an inert gas heavier than said Ar using a box cathode sputtering method or a facing target sputtering method.

## Description

### BACKGROUND OF THE INVENTION

### 1. Field of the Invention

The present embodiments relate to an organic light emitting display and a deposition method, and more specifically to an organic light emitting display and a deposition method for depositing an electrode or a passivation layer by means of a box cathode sputtering method or a facing target sputtering method by mixing Ar with an inert gas heavier than Ar.

### 2. Description of the Related Art

Generally, a high-quality film formation of a transparent electrode (in the case of a top emission) or metal electrode (in the case of a bottom emission) for supplying electrons is required for manufacturing an organic light emitting display with a top emission or bottom emission type.

In order to easily supply an electron to an organic material, Mg, Ca and Li, which have a low work function, are used as metal electrodes of such an organic light emitting display since a low difference of work function with the organic materials allow a barrier to be reduced, but it is difficult to apply to the bottom emission type since such materials have a lowered reflectivity to the light. Accordingly, Al, Ag, etc. have been used as materials having a low difference of work function with the organic materials and a high reflectivity, which are deposited by the conventional thermal evaporation/deposition processes.

Among the materials, Al has been recently used in the most organic light emitting displays since the injection property of electrons is improved by its interfacial reaction with LIF/Alq₃. However, Al is problematic at high process temperatures since it has a relatively low melting temperature and a high equilibrium vapor pressure, and therefore it is vaporized when it is heated to a temperature of about 1,300 °C. That is to say, BN (boron nitride) boats, PBN (pyrolytic boron nitride) boats, etc., recently used in the thermal evaporation/deposition process of Al, are reacted with Al at about 1,300 °C, but the inside of the melting pot is easily cracked at a high temperature when it is cooled, and therefore the problem is that it has a low stability and a short period of usage of the melting pot. And, arrangement of a metal mask and a substrate is affected by the high temperature of 1,300 °C, and therefore the process is carried out while pacing apart a maximum distance between a boat and the substrate, but the problem is that it has a significantly reduced deposition rate.

Also, Al is easily propagated through the microcracks within the melting pot due to its propagation property in the high temperature, and therefore there is the problem that the cracks get extended when it is cooled, and also that a short circuit appears in the power applying unit.

In addition, a point source-type melting pot has been used as a boat for Al, but it has a problem that it is not suitable for manufacturing a large-sized organic light emitting display later.

For manufacturing a large-sized organic light emitting displays, a sputter depositing method has been used for depositing general transparent electrodes or metal electrodes. At this time, the inert gas Ar is used as a process gas, and a DC or RF power source is used.

However, if the target is deposited by sputtering in the sputter depositing method, organic materials exposed to a surface deposited on the substrate by plasma are affected, resulting in degeneration of the organic materials.

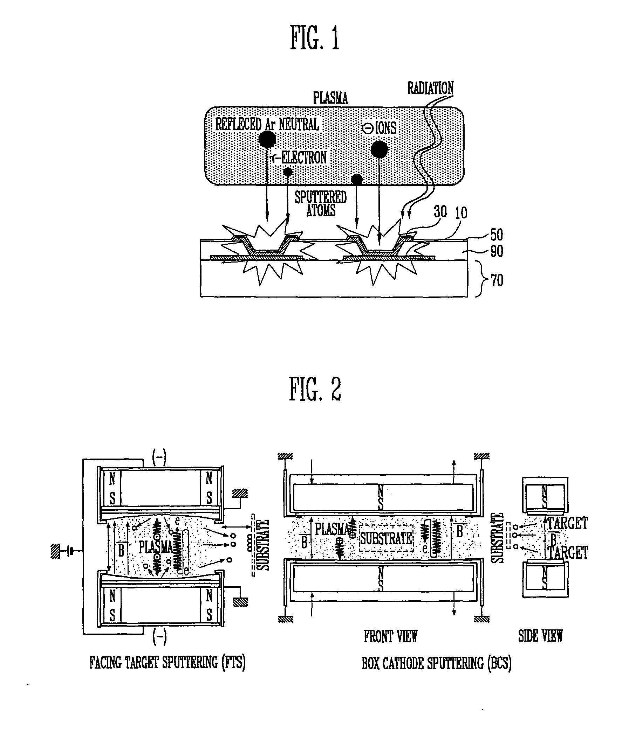

Referring to FIG. 1 showing an apparatus in which degeneration of the organic materials occurs, if electrodes 50 are deposited with an Ar inert gas on a first electrode 10 formed on a thin film transistor 70, and an organic layer 30 formed on the first electrode 10, then the problem is that properties of the final products are adversely affected by colliding neutral Ar, anionic particles, cationic particles and thermions, etc., which have a high energy, with the organic layer 30 formed in the upper surface of the substrate. The increased temperature of the substrate, the re-sputtering phenomenon, the interfacial reaction and the secondary generation of the electron are caused by the energy transmitted by its collision, and therefore the properties of the products such as bad devices, a reduced emission efficiency, etc. are affected adversely.

Reference numeral 90 represents a barrier rib.

Organic materials constituting an organic layer of the organic light emitting display mainly formed a C-C bond or a C-H bond, and such a bond is easily decomposed by the collision of the particles having an energy of at least 100 eV.

In the case of Alq₃ constituting an organic layer of the organic light emitting display, the conventional sputter processes for depositing a target by sputtering it as Ar⁺ is to use a DC or RF power source since N-Al and C-O-Al bonds are easily decomposed by the collision of O⁻, neutral Ar and Ar⁺ ion, which have an energy of at least 100 eV.

In order to reduce such an adverse effect appearing on the organic layer, a buffer layer such as copper pthalocyanine (CuPc), 3,4,9,10-perylenetetracarboxylic dianhydride (PTCDA) or Li-doped 2,9-dimethyl-4,7-diphenlyl-1,10-phenanthroline (BCP) may be used, but such use causes manufacturing cost to increase, and also the adverse effect on the organic layer is not completely solved despite of the development of such a process.

Also, deposition of a passivation layer to be deposited on a thin film transistor has the problem that damage to a deposited surface by plasma remains.

In addition, there is required a deposition method capable of realizing a thin-film structure, namely a structure of a multiple-layered electrode and a multiple-layered passivation layer, which meets the user's demand according to the desired properties of the device.

### SUMMARY OF THE INVENTION

The present embodiments describe an organic light emitting display and a deposition method having a structure without an organic layer, which deposits an electrode or a passivation layer by means of a box cathode sputtering method or a facing target sputtering method by mixing Ar with an inert gas heavier than Ar.

Another object of the present embodiments is to provide an organic light emitting display and a deposition method capable of depositing a passivation layer without any damage by plasma.

In addition, another object of the present embodiments is to provide an organic light emitting display and a deposition method designed to deposit an electrode or a passivation layer onto multiple layers according to the properties required by the users.

Additionally, another object of the present embodiments is to provide an organic light emitting display and a deposition method designed to improve its yield by depositing an electrode or a passivation layer using a continuous process rather than a batch processes.

The foregoing and/or other aspects of the present embodiments are achieved by providing an organic light emitting display including a substrate; a thin film transistor formed on the substrate; a first electrode formed on the thin film transistor; an organic layer formed on the first electrode; and a second electrode layer sputter-deposited on the organic layer by mixing Ar gas with an inert gas heavier than Ar gas using a box cathode sputtering method or a facing target sputtering method.

In some embodiments, the inert gas heavier than Ar is at least one material selected from the group consisting of Kr, Xe and Rn, and the mixing ratio of said Ar to the inert gas heavier than Ar is preferably from about 1:0.001 to about 1:1, and more preferably from about 1:0.001 to about 1:0.55.

In other embodiments, the box cathode sputtering method or the facing target sputtering method has a process pressure of about 0.1 to about 100 mTorr.

Also, a target of the box cathode sputtering method or the facing target sputtering method may be at least one material selected from the group consisting of Mg, Ag, Al, Li and Ca, and a target of the box cathode sputtering method or the facing target sputtering method may be at least one material selected from the group consisting of transparent conductive materials including ITO (indium tin oxide), doped ITO, IZO (indium zinc oxide), doped IZO, ZnO and doped ZnO.

In addition, the second electrode layer deposited on the organic layer may be formed onto multiple layers, and the second electrode layer formed onto the multiple layers may be an electrode layer in which at least one material selected from the group consisting of a transparent material, an opaque material and a transparent/opaque mixture may be mutually formed onto multiple layers.

Another embodiment relates to an organic light emitting display including a substrate; a thin film transistor formed on the substrate; a passivation layer sputter-deposited on the thin film transistor by mixing Ar gas with an inert gas heavier than Ar gas using a box cathode sputtering method or a facing target sputtering method; a first electrode formed on the passivation layer; an organic layer formed on the first electrode; and a second electrode layer formed on the organic layer.

In some embodiments the inert gas heavier than said Ar is at least one material selected from the group consisting of Kr, Xe and Rn, and a mixing ratio of said Ar to the inert gas heavier than Ar is preferably from about 1:0.001 to about 1:1, and more preferably from about 1:0.001 to about 1:0.55.

Preferably, the box cathode sputtering method or the facing target sputtering method has a process pressure of from about 0.1 to about 100 mTorr.

Also, targets of the box cathode sputtering method or the facing target sputtering method include, for example, at least one of Si, Si oxides including SiO₂, Si nitrides including SiNₓ, and Al oxides.

In addition, the passivation layer may be formed onto multiple layers, and the passivation layer formed onto the multiple layers may be a passivation layer in which at least one material selected from the group consisting of Si, Si oxides, Si nitrides and Al oxides may be mutually formed onto multiple layers.

Some other embodiments relate to a deposition method for depositing material on a substrate by sputtering targets with Ar gas, wherein the Ar gas is mixed with an inert gas heavier than Ar gas, and the sputtering method is a box cathode sputtering method or a facing target sputtering method.

The targets can be configured so that their multiple pairs can be arranged to face each other, and the substrate is configured so that the materials sputtered in each of the multiple pairs of the targets can be deposited to allow a translational motion or a reciprocating motion, and the deposition materials are deposited in the form of multiple layers on a deposited surface of the substrate.

According to a first aspect of the invention, there is provided a method as set out in Claim 1. Preferred features of this aspect are set out in Claims 2 to 18.

### BRIEF DESCRIPTION OF THE DRAWINGS

These and other aspects and advantages of the embodiments will become apparent and more readily appreciated from the following description of the preferred embodiments, taken in conjunction with the accompanying drawings of which:

FIG. 1 is a cross-sectional view showing damage of a substrate by plasma generated when an electrode is deposited using the conventional sputtering methods;

FIG. 2 is a schematic view showing a facing target sputtering method and a box cathode sputtering method according to a preferred embodiment;

FIG. 3 is a diagram and a photographic image showing a result of measured current-voltage properties of the organic light emitting display in which electrodes are deposited using a conventional sputtering method;

FIG. 4 is a diagram showing the result of measured current-voltage properties of the organic light emitting display in which electrodes are deposited using a facing target sputtering method and a box cathode sputtering method according to one embodiment;

FIG. 5 is a diagram and a photographic image showing the result of measured current-voltage properties of the organic light emitting display in which electrodes are deposited using a facing target sputtering method and a box cathode sputtering method according to a preferred embodiment;

FIG. 6 is a diagram showing the result of an Auger electron spectroscopic analysis of the organic light emitting display in which electrodes are deposited using a facing target sputtering method according to a preferred embodiment;

FIG. 7 is a schematic view showing a facing target sputtering method and a box cathode sputtering method according to another embodiment;

FIG. 8a is a cross-sectional view showing a structure where a buffer layer is omitted in a top-emission organic light emitting display in which electrodes are deposited using a facing target sputtering method or a box cathode sputtering method according to a preferred embodiment;

FIG. 8b is a cross-sectional view showing a structure where a buffer layer is omitted in a bottom-emission organic light emitting display in which electrodes are deposited using a facing target sputtering method or a box cathode sputtering method according to a preferred embodiment;

FIG. 9a is a cross-sectional view showing a structure where a buffer layer is omitted in a top-emission organic light emitting display in which electrodes are deposited using a facing target sputtering method or a box cathode sputtering method according to another embodiment;

FIG. 9b is a cross-sectional view showing a structure where a buffer layer is omitted in a bottom-emission organic light emitting display in which electrodes are deposited using a facing target sputtering method or a box cathode sputtering method according to another embodiment;

FIG. 10 is a cross-sectional view showing an organic light emitting display in which a passivation layer is deposited using a facing target sputtering method or a box cathode sputtering method according to yet another embodiment; and

FIG. 11 is a cross-sectional view showing an organic light emitting display in which a passivation layer composed of a plurality of layers is deposited using a facing target sputtering method or a box cathode sputtering method according to yet another embodiment.

### DETAILED DESCRIPTION OF PREFERRED EMBODIMENTS

Hereinafter, preferable embodiments of the deposition method according to the present embodiments will be described with reference to the accompanying drawings.

FIG. 2 is a schematic view showing a facing target sputtering method and a box cathode sputtering method according to a preferred embodiment.

In a preferred embodiment, a facing target sputtering method or a box cathode sputtering method is used, and a mixture of Ar gas and an inert gas heavier than Ar gas is used as a process gas.

In the facing target sputtering method and the box cathode sputtering method as shown in FIG. 2, high-density plasma may be generated by a high-density magnetic field formed between the facing targets. Ions or electrons within the plasma engage in reciprocating motion which alternates between the target and the the other target, and simultaneously engage in rotatory motion along the line of magnetic force since the high-density magnetic field formed between the targets is formed in one direction, and a negative (-) bias is applied to the target in its operation.

The thin films may grow quickly by generating the high-density plasma and using a pair of facing targets, and since the substrate to be deposited is positioned on the outside of the plasma region entrapped by the high-density magnetic field formed between the targets in one direction, its damage by plasma is minimized.

However, it is difficult to transfer energy to sputtered particles having a high energy since gases such as Ar, He, etc., which are inert gases that generate plasma, are light-weight. Accordingly, if a mixture of Ar gas and an inert gas heavier than Ar gas are used in conducting such a facing target sputtering method or a box cathode sputtering method, then it does not affect the organic layer because high-energy particles generated in the sputtering process collide with heavy inert gases and lose their energies. The sputtered particles also collide with heavy inert gases and lose their energies, and therefore they are low in their energy levels and deposited on the organic layer. The organic layer is not damaged by the particles deposited with such low energies in the deposition process.

In some embodiments, mixtures of Ar+Kr, Ar+Xe, Ar+Rn, Ar+Kr+Xe, Ar+Kr+Rn, Ar+Xe+Rn and Ar+Kr+Xe+Rn, for example, may be used as the process gas.

In some embodiments Mg, Ag, Al, Li and Ca, which can be used for the electrode materials, may be also used as the target, and transparent conductive materials such as ITO (Indium Tin Oxide), doped ITO, IZO (Indium Zinc Oxide), doped IZO, ZnO and doped ZnO may also be used.

Also, materials such as Si, Si oxides including SiO₂, Si nitrides including SiNₓ, Al oxides, etc. may be used in the process for forming a passivation layer on the thin film transistor substrate in which a source electrode, a drain electrode and a gate electrode are formed.

Hereinafter, preferred embodiments will be described in detail, taken in conjunction with the accompanying drawings.

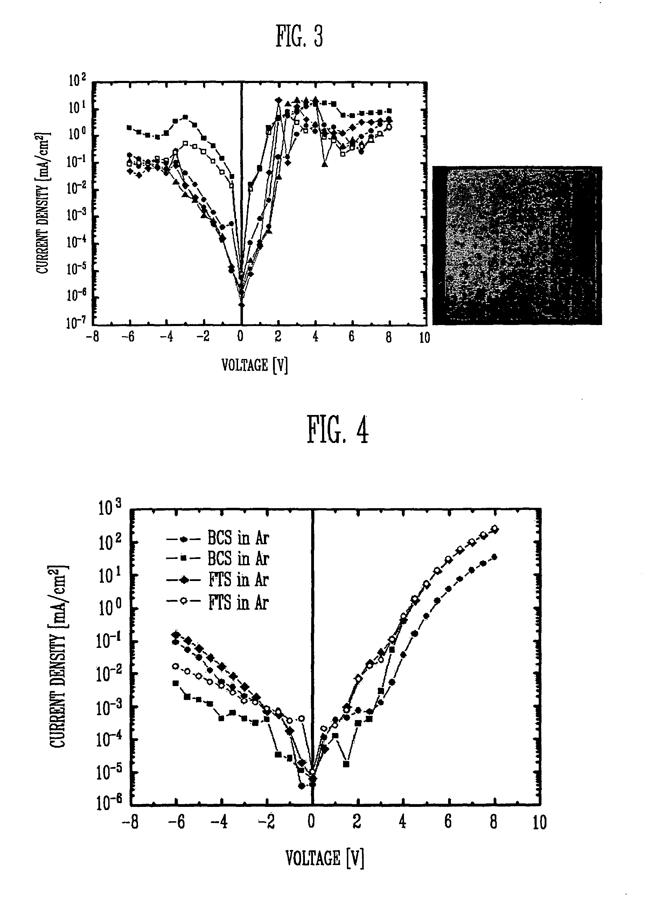

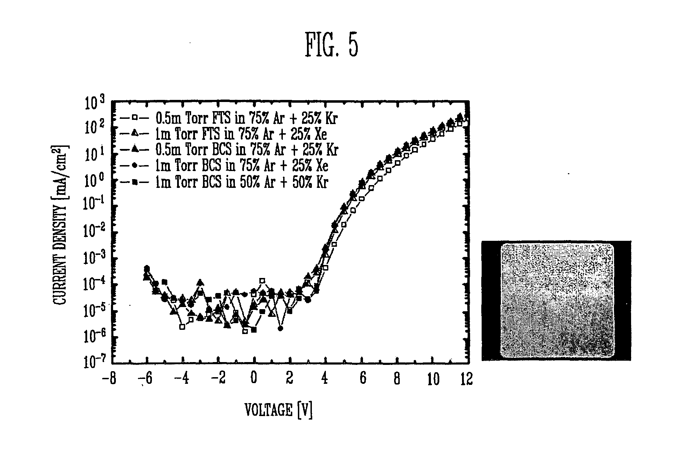

FIG. 3 is a diagram and a photographic image showing the result of measured current-voltage properties of the organic light emitting display in which electrodes are deposited using a conventional sputtering method; and FIG. 4 is a diagram showing the result of measured current-voltage properties of the organic light emitting display in which electrodes are deposited using a facing target sputtering method and a box cathode sputtering method according to one embodiment.

Referring to FIG. 3, when a 100 nm thick film of Al is formed under 5 mTorr of process pressure obtained by an inflow of 20 sccm of Ar using the conventional sputtering method, the properties of the organic materials are affected since the particles with high energies collide with the organic layer on the substrate to transfer the high energy. Accordingly, the current-voltage properties of the organic light emitting display manufactured thus shows a high leakage current in the reverse-bias region, and also a leakage current in the forward-bias region.

As shown in the photograph showing such an effect, it is seen that a plurality of black spots are present on the organic light emitting display representing leakage current.

Referring to FIG. 4, it is revealed that the leakage current shown in the current-voltage properties of the organic light emitting display in which only Ar gas is used as the process gas to deposit Al electrodes by means of the box cathode sputtering method and the facing target sputtering method, is rather reduced in the forward-bias region, compared to the leakage current of the organic light emitting display manufactured by the conventional sputtering method as shown in FIG. 3, but the leakage current is still detected in the reverse-bias region.

That is why Al is still deposited with a high energy on the surface to be deposited which damages the organic layer since the weight of Al to be sputtered (27 amu.) is not significantly different from a weight of Ar (40 amu.), and therefore the energies are not sufficiently transferred upon collision.

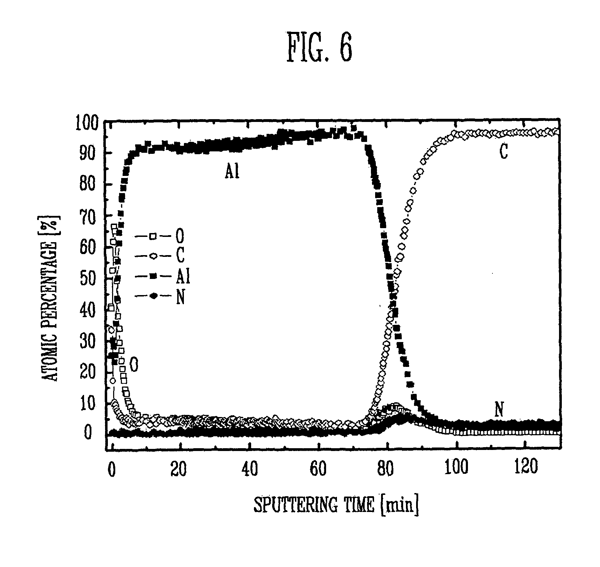

FIG. 5 is a diagram and a photographic image showing the result of measured current-voltage properties of the organic light emitting display in which electrodes are deposited using a facing target sputtering method and a box cathode sputtering method according to a preferred embodiment; and FIG. 6 is a diagram showing the result of an Auger electron spectroscopic analysis of the organic light emitting display in which electrodes are deposited using a facing target sputtering method according to a preferred embodiment.

In the graph showing the current-voltage properties of the organic light emitting display in which electrodes are deposited using the facing target sputtering (FTS) method and the box cathode sputtering (BCS) and using Ar+Kr and Ar+Xe as the process gases, its properties are more improved than the measured values as shown in FIGs. 3 and 4, as shown in FIG. 5. That is to say, it is seen that the leakage current is significantly reduced in the reverse and forward bias.

Also, it is observed from the photographic image of the organic light emitting display shown in FIG. 5 that the organic light emitting display, which has significantly reduced black points and therefore a clear image when compared to the photographic image of FIG. 3, is manufactured.

When such a method is used, a mixing ratio of Ar to inert gas heavier than said Ar preferably from about 1:0.001 to about 1:1 of Ar vs. inert gas heavier than said Ar.

More preferably, a mixing ratio of Ar to inert gas heavier than said Ar ranges from about 1:0.001 to about 1:0.55.

Total process pressure preferably ranges from about 0.01 to about 100 mTorr.

Referring to FIG. 6 showing a result of an Auger electron spectroscopic analysis of the organic light emitting display in which Al electrodes are deposited using such a method, it is revealed that the reaction almost never appear between Al, deposited as the electrode, and the organic materials, and therefore the interfacial properties is improved.

Hereinafter, another embodiment of the deposition method according to the present embodiments will be described in detail, taken in conjunction with the accompanying drawings.

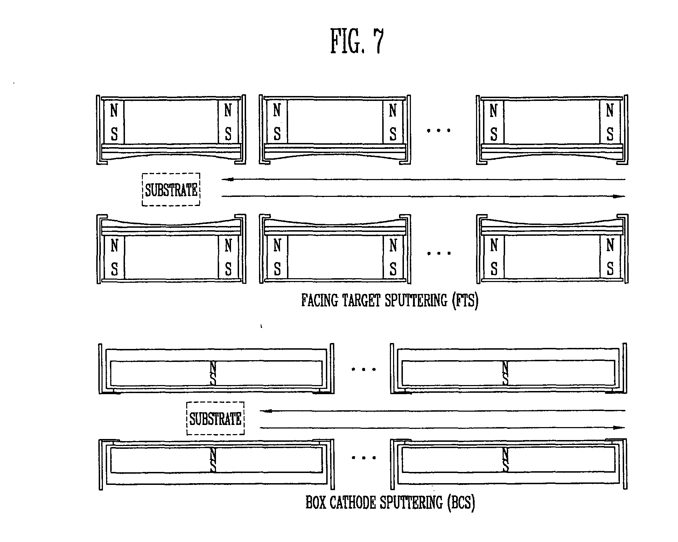

FIG. 7 is a schematic view showing a facing target sputtering method and a box cathode sputtering method according to another embodiment.

The deposition method according to another embodiment relates to a deposition method in which matter is deposited on a substrate by sputtering targets with Ar gas, wherein the sputtering method is a box cathode sputtering method or a facing target sputtering method; the targets are configured so that their multiple pairs can be arranged to face each other; the substrate is configured so that the materials sputtered in each of the multiple pairs of the targets can be deposited to allow a translational motion or a reciprocating motion; and the Ar gas is mixed with an inert gas heavier than Ar gas.

Referring to FIG. 7, a box cathode-type target or a facing target composed of a plurality of its pairs is translationally arranged, and each of the targets composed of a plurality of the pairs may be formed into other pairs of the materials.

The substrate is designed so that it can engage in translational motion or reciprocating motion to the box cathode-type target or the facing target, which are composed of a plurality of their pairs, so as to deposit the sputtered materials on the target. That is to say, the substrate is designed for each pair so that the target materials composted of each of the pairs can be deposited on the substrate to move in directions as shown by arrows in FIG. 7.

According to such a deposition method, desired materials may be deposited in the form of multiple layers on the substrate in only one process, and due to the reason described above, the deposition may be carried out without any damage to the substrate surface by plasma by using the mixed gas in which Ar is mixed with the inert gas heavier than Ar gas.

In addition, to realize deposition of the thin film in the form of the multiple layers on the substrate, such a method may be useful to mass-produce the products since the vacuum deposition method, which has been carried out only as the conventional batch-type process, may be conducted as a series-type process if it is applied to an in-line form of equipment.

The mixed gases of Ar and the inert gas heavier than Ar gas, for example Ar+Kr, Ar+Xe, Ar+Rn, Ar+Kr+Xe, Ar+Kr+Rn, Ar+Xe+Rn and Ar+Kr+Xe+Rn may be used as the process gas, and a mixing ratio of Ar to the inert gas heavier than Ar gas is preferably from about 1:0.001 to about 1:1, and more preferably from about 1:0.001 to about 1:0.55.

Also, a process pressure of the box cathode sputtering method or the facing target sputtering method, which uses the targets in which their multiple pairs can be arranged to face each other, ranges from about 0.1 to about 100 mTorr.

Mg, Ag, Al, Li and Ca, which can be used for the electrode materials, may be used as the target, and the transparent conductive materials such as ITO (Indium Tin Oxide) and doped ITO, IZO (Indium Zinc Oxide) and doped IZO, and ZnO and doped ZnO, etc. may be also used. The listed materials may be deposited in the form of single or multiple layers, depending on the desired properties, on the substrate for organic light emitting display where the organic materials are formed on its deposited surface.

Also, materials such as Si, Si oxides including SiO₂, Si nitrides including SiNₓ, Al oxides, etc. may be used in the process for forming a passivation layer on the thin film transistor substrate in which a source electrode, a drain electrode and a gate electrode are formed. The listed materials may be deposited in the form of single or multiple layers, depending on the desired properties, on the substrate for organic light emitting display where the source electrode, the drain electrode and the gate electrode are formed on its deposited surface.

Hereinafter, another embodiment of the organic light emitting display according to the present embodiments will be described in detail, taken in conjunction with the accompanying drawings.

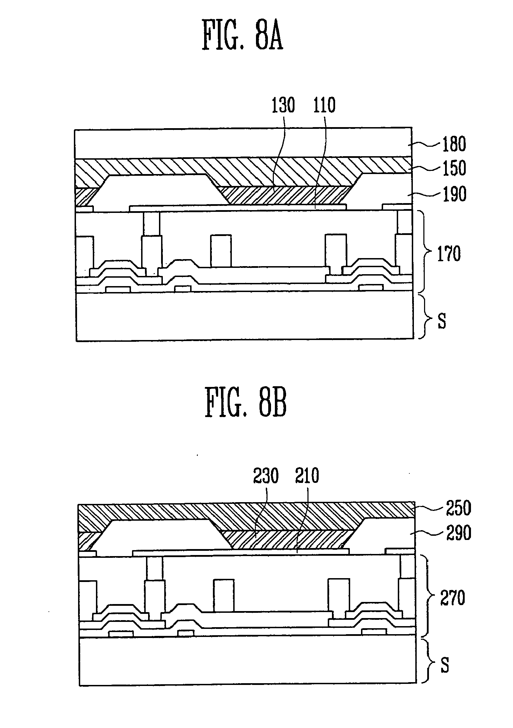

FIG. 8a is a cross-sectional view showing a structure where a buffer layer is omitted in a top-emission organic light emitting display in which electrodes are deposited using a facing target sputtering method or a box cathode sputtering method according to a preferred embodiment; and FIG. 8b is a cross-sectional view showing a structure where a buffer layer is omitted in a bottom-emission organic light emitting display in which electrodes are deposited using a facing target sputtering method or a box cathode sputtering method according to a

### preferred embodiment.

The organic light emitting display according to a preferred embodiment includes a substrate S, thin film transistors 170, 270 formed on the substrate S, first electrodes 110, 210 formed on the thin film transistor 170, 270, organic layers 130, 230 (see FIGs 8A and 8B respectively) formed on the first electrode 110, 210 (see FIGs 8A and 8B respectively), and second electrode layers 150, 250 (see FIGs 8A and 8B respectively) sputter-deposited on the organic layer 130, 230 (see FIGs 8A and 8B respectively) by mixing Ar gas with an inert gas heavier than Ar gas using the box cathode sputtering method or the facing target sputtering method.

Reference numeral 180 represents a transparent protective film, and reference numerals 190 and 290 (see FIGs 8A and 8B respectively) represent a barrier rib, respectively.

The second electrode layers 150, 250 (see FIGs 8A and 8B respectively) are deposited on the organic layer by mixing Ar gas with an inert gas heavier than Ar gas using the box cathode sputtering method or the facing target sputtering method. And, a structure of the buffer layer such as copper pthalocyanine (CuPc), 3,4,9,10-perylenetetracarboxylic dianhydride (PTCDA) and Li-doped 2,9-dimethyl-4,7-diphenlyl-1,10-phenanthroline (BCP) may be omitted between the second electrode layers 150, 250 and the organic layers 110, 210 in the organic light emitting display according to the preferred embodiment. Accordingly, its process time and its material cost may be reduced.

A transparent electrode 150 of Mg-Ag/ITO can be wired in the top-emission method of FIG. 8a, and an Al electrode 250 can be wired in the bottom-emission method of FIG. 8b.

Hereinafter, another embodiment of an organic light emitting display according to the present embodiments will be described in detail, taken in conjunction with the accompanying drawings.

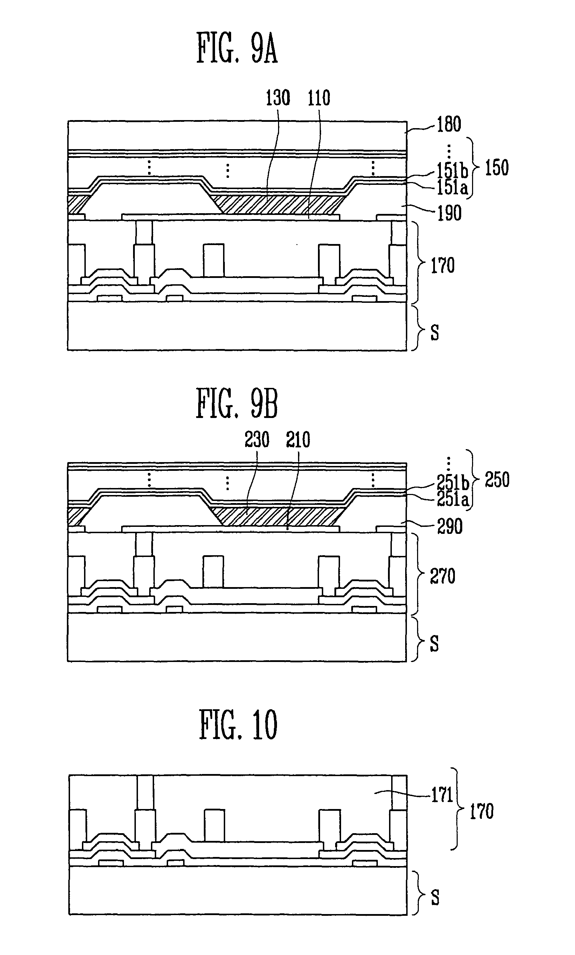

FIG. 9a is a cross-sectional view showing a structure where a buffer layer is omitted in a top-emission organic light emitting display in which electrodes are deposited using a facing target sputtering method or a box cathode sputtering method according to another embodiment; and FIG. 9b is a cross-sectional view showing a structure where a buffer layer is omitted in a bottom-emission organic light emitting display in which electrodes are deposited using a facing target sputtering method or a box cathode sputtering method according to another embodiment.

The organic light emitting display according to another embodiment includes a substrate S, thin film transistors 170, 270 formed on the substrate S, first electrodes 110, 210 formed on the thin film transistors 170, 270, organic layers 130, 230 (see FIGs 9A and 9B respectively) formed on the first electrodes 110, 210 (see FIGs 9A and 9B respectively), and second electrode layers 150, 250 (see FIGs 9A and 9B respectively) sputter-deposited in the form of the multiple layers on the organic layers 130, 230 (see FIGs 9A and 9B respectively) by mixing Ar gas with an inert gas heavier than Ar gas using a box cathode sputtering method or a facing target sputtering method.

Reference numeral 180 represents a transparent protective film, and reference numerals 190 and 290 represent a barrier rib, respectively.

The second electrode layers 150, 250 (see FIGs 9A and 9B respectively) are deposited on the organic layer by mixing Ar gas with an inert gas heavier than Ar gas using the box cathode sputtering method or the facing target sputtering method, which uses the targets configured so that their multiple pairs can be arranged to face each other, and by configuring the substrate so that the materials sputtered in each of the multiple pairs of the targets can be deposited to allow a translational motion or a reciprocating motion. And, a structure of the buffer layer such as copper pthalocyanine (CuPc), 3,4,9,10-perylenetetracarboxylic dianhydride (PTCDA) and Li-doped 2,9-dimethyl-4,7-diphenlyl-1,10-phenanthroline (BCP) may be omitted between the second electrode layers 150, 250 (see FIGs 9A and 9B respectively) and the organic layers 110, 210 (see FIGs 9A and 9B respectively) in the organic light emitting display according to a preferred embodiment. Accordingly, process time and material cost may be reduced.

As shown in FIGs. 9a and 9b, the second electrode layers 150, 250 may be formed into a plurality of layers 151a, 151b,..., 251a, 251b,..., and therefore the second electrode layers 150, 250 may be designed depending on the properties required by the users.

Transparent conductive materials such as ITO and doped ITO, IZO and doped IZO, and ZnO and doped ZnO can be in the form of multiple layers as the transparent electrode 150 in the top-emission method of FIG. 9a, and materials such as Mg, Ag, Al, Li and Ca can be in the form of the multiple layers as the electrode 250 in the bottom-emission method of FIG. 9b.

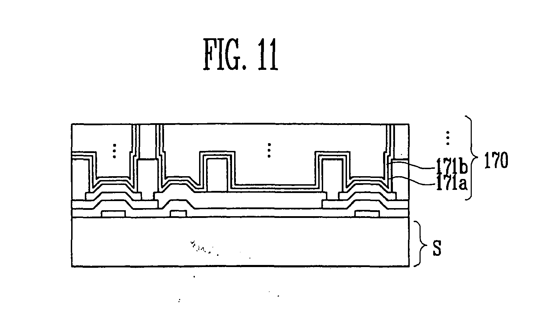

Hereinafter, still another embodiment of the organic light emitting display according to the present embodiments will be described in detail, taken in conjunction with the accompanying FIG. 10.

FIG. 10 is a cross-sectional view showing an organic light emitting display in which a passivation layer is deposited using a facing target sputtering method or a box cathode sputtering method according to yet another embodiment.

The organic light emitting display according to yet another embodiment includes a substrate S, a thin film transistor 170 formed on the substrate S, a passivation layer 171 sputter-deposited on the thin film transistor 170 by mixing Ar gas with an inert gas heavier than Ar gas using the box cathode sputtering method or the facing target sputtering method, a first electrode formed on the passivation layer 171, an organic layer formed on the first electrode, and a second electrode layer formed on the organic layer.

The passivation layer 171 can be at least one material selected from the group consisting of Si, Si oxides, Si nitrides and Al oxides.

The passivation layer 171 is deposited by mixing Ar gas with an inert gas heavier than Ar gas using the box cathode sputtering method or the facing target sputtering method. And, the passivation layer may be deposited on the surface by the deposition method according to an embodiment without any damage to the passivation layer by plasma.

Hereinafter, still another embodiment of the organic light emitting display according to the present embodiments will be described in detail, taken in conjunction with the accompanying FIG. 10.

FIG. 11 is a cross-sectional view showing an organic light emitting display in which a passivation layer composed of a plurality of layers is deposited using a facing target sputtering method or a box cathode sputtering method according to yet another embodiment.

The organic light emitting display according to yet another embodiment includes a substrate S, a thin film transistor 170 formed on the substrate S, a passivation layer 171 sputter-deposited on the thin film transistor 170 by mixing Ar gas with an inert gas heavier than Ar gas using the box cathode sputtering method or the facing target sputtering method, a first electrode formed on the passivation layer 171, an organic layer formed on the first electrode, and a second electrode layer formed on the organic layer.

Here, the passivation layers 171a, 171b,... formed into the multiple layers are passivation layers in which at least one material selected from the group consisting of Si, Si oxides, Si nitrides and Al oxides is mutually formed into multiple layers.

The passivation layer 171 is deposited on the organic layer by mixing Ar gas with an inert gas heavier than Ar gas using the box cathode sputtering method or the facing target sputtering method, which uses the targets configured so that their multiple pairs can be arranged to face each other, and by configuring the substrate so that the materials sputtered in each of the multiple pairs of the targets can be deposited to allow a translational motion or a reciprocating motion. And, the passivation layer may be deposited on the surface by the deposition method according to an embodiment without any damage to the passivation layer by plasma, and the passivation layer 171 may be formed into a plurality of layers 171a, 171b,..., and therefore the passivation layer 171 may be formed depending on the properties required by the users.

The description and the accompanying drawings described herein are just a preferable example for the purpose of illustrations only, not intended to limit the meanings or the scope of the embodiments as defined in the appended claims. Therefore, it should be understood that other equivalents and modifications could be made thereto without departing from the scope of the embodiments, as is apparent to those skilled in the art from this detailed description. Accordingly, the technical scope to be protected according to the present embodiments should be defined by the appended claims, but not in the context described in the detailed description of the application.

As described above, the organic light emitting display and the deposition method according to the present embodiments may be useful to improve the yield of the products since it is possible to deposit the electrode on the organic layer without damage by plasma in the absence of the buffer layer, and it is also suitable for a process for manufacturing large-sized organic light emitting displays and favorable for its maintenance and repair because a large-sized film formation is favorable when compared to the conventional thermal evaporation/deposition processes such as a point source method, and it is also possible to deposit a high-quality electrode having an improved adhesion and an improved interfacial property, using the sputtering method, when compared to the thermal evaporation/deposition processes.

Also, the passivation layer may be deposited without damage by plasma in the deposition method of the passivation layer.

In addition, the electrodes or the passivation layers may be designed to be deposited into the multiple layers, depending on the user's demand.

Also, the yield of the final products may be improved by depositing the electrodes or the passivation layers using the continuous process rather than the conventional batch processes.

## Claims

1. A method of depositing matter on a substrate comprising:
sputtering a target with Ar gas, wherein the Ar gas is mixed with an inert gas heavier than said Ar gas, and wherein the sputtering method is a box cathode sputtering method or a facing target sputtering method.

2. A method according to claim 1, comprising sputtering a plurality of said targets, wherein the sputtering targets are configured so that they can be arranged to face each other and the materials sputtered in each of the targets can be deposited while the substrate engages in a translational motion or a reciprocating motion.

3. A deposition method according to claim 1 or 2, wherein deposition materials are deposited in the form of multiple layers on the substrate.

4. A method of manufacturing an organic light emitting display using a method according to any one of claims 1 to 3, further comprising:
forming a thin film transistor on the substrate;
forming a first electrode on the thin film transistor; and
forming an organic layer on the first electrode; wherein:
the depsited material comprises a second electrode layer sputter-deposited on the organic layer.

5. A method according to any one of claims 1 to 4, wherein a said target is at least one material selected from the group consisting of Mg, Ag, Al, Li and Ca.

6. A method according to any one of claims 1 to 4, wherein a said target is a transparent conductive material.

7. A method according to claim 6, wherein the transparent conductive material comprises at least one selected from the group consisting of ITO, doped ITO, IZO, doped IZO, ZnO and doped ZnO.

8. A method according to any one of claims 4 to 7, wherein the second electrode layer deposited on the organic layer is formed into multiple layers.

9. A method according to any one of claims 4 to 7, wherein the second electrode layer comprises at least one selected from the group consisting of a transparent material, an opaque material and a transparent/opaque mixture.

10. A method of manufacturing an organic light emitting display using a method according to any one of claims 1 to 3, further comprising:
forming a thin film transistor on the substrate, wherein the deposited material comprises:
a passivation layer sputter-deposited on the thin film transistor; the method further comprising:
forming a first electrode on the passivation layer;
forming an organic layer on the first electrode; and
forming a second electrode layer on the organic layer.

11. A method according to any one of claims 1 to 18, wherein the inert gas heavier than Ar gas is at least one material selected from the group consisting of Kr gas, Xe gas and Rn gas.

12. A method according to any one of claims 1 to 11, wherein the mixing ratio of said Ar gas to the inert gas heavier than Ar gas is from about 1:0.001 to about 1:1.

13. A method according to any one of claims 1 to 12, wherein the mixing ratio of said Ar gas to the inert gas heavier than Ar gas is from about 1:0.001 to about 1:0.55.

14. A method according to any one of claims 1 to 13, wherein the box cathode sputtering method or the facing target sputtering method has a process pressure of from about 0.1 to about 100 mTorr.

15. A method according to any preceding claim, wherein the target of the box cathode sputtering method or the facing target sputtering method is at least one material selected from the group consisting of Si, Si oxides, Si nitrides and Al oxides.

16. A method according to claim 15, wherein the target of the box cathode sputtering method or the facing target sputtering method comprise SiO₂ and/or SiNₓ.

17. A method according to claim 10, or any claim dependent on claim 10, wherein the passivation layer is formed into multiple layers.

18. A method according to claim 17, wherein the passivation layer formed into the multiple layers comprises at least one material selected from the group consisting of Si, Si oxides, Si nitrides and Al oxides.
